# EUROPEAN PATENT APPLICATION

(11) **EP 4 475 191 A1**
(43) Date of publication of application: **11.12.2024**
(21) Application number: 24153617.6
(22) Date of filing: 24.01.2024
(51) Int. Cl.: H01L 29/08, H01L 29/167, H01L 29/775

(54) **SEMICONDUCTOR DEVICE WITH METAL-DOPED SOURCE/DRAIN REGION**

(30) Priority: 08.06.2023 KR 20230073392
(71) Applicant: Samsung Electronics Co., Ltd., Suwon-si, Gyeonggi-do 16677 (KR)
(72) Inventor: NAM, Yong Jun, 16677 Suwon-si (KR); KIM, Jin Bum, 16677 Suwon-si (KR); LEE, Sang Moon, 16677 Suwon-si (KR); KIM, Gyeom, 16677 Suwon-si (KR); KIM, Hyo Jin, 16677 Suwon-si (KR); LEE, Tae Hyung, 16677 Suwon-si (KR); HWANG, In Geon, 16677 Suwon-si (KR)
(74) Representative: Marks & Clerk LLP

(57) **Abstract**

A semiconductor device includes: a substrate (100), an active pattern (101) extending in a first horizontal direction (DR1) on the substrate, a plurality of nanosheets (NW1 .. NW4) spaced apart from each other and stacked in a vertical direction on the active pattern, a gate electrode (G) extending in a second horizontal direction (DR2) different from the first horizontal direction on the active pattern, the gate electrode surrounding the plurality of nanosheets, a source/drain region (120) disposed on at least one side of the gate electrode on the active pattern, the source/drain region including a first layer (121) doped with a metal, and a second layer (122) disposed on the first layer, and an inner spacer (130) disposed between the gate electrode and the first layer, between each of the plurality of nanosheets, the inner spacer in contact with the first layer, the inner spacer including a metal oxide formed by oxidizing the same material as the metal.

## Description

### BACKGROUND

The present disclosure relates to a semiconductor device. Specifically, the present disclosure relates to a semiconductor device including an MBCFET^{™} (Multi-Bridge Channel Field Effect Transistor).

As an example of scaling technologies for increasing density of integrated circuit devices, a multi-gate transistor includes a silicon body having a fin or nanowire shape and formed on a substrate and a gate formed on a surface of the silicon body.

Since such a multi-gate transistor utilizes a three-dimensional channel, scaling is easily performed. Further, even if a gate length of the multi-gate transistor is not increased, the current control capability may be improved. Furthermore, a short channel effect (SCE) in which potential of a channel region is influenced by a drain voltage may be effectively suppressed.

### SUMMARY

Aspects of the present disclosure provide a semiconductor device in which reliability for each of a source/drain region and an inner spacer is improved.

However, aspects of the present disclosure are not restricted to those forth herein. The above and other aspects of the present disclosure will become more apparent to one of ordinary skill in the art to which the present disclosure pertains by referencing the detailed description of the present disclosure given below.

In general, innovative aspects of the subject matter described in this specification can be embodied in semiconductor devices that include: a substrate, an active pattern extending in a first horizontal direction on the substrate, a plurality of nanosheets spaced apart from each other and stacked in a vertical direction on the active pattern, a gate electrode extending in a second horizontal direction different from the first horizontal direction on the active pattern, the gate electrode surrounding the plurality of nanosheets, a source/drain region disposed on at least one side of the gate electrode on the active pattern, the source/drain region including a first layer doped with a metal, and a second layer disposed on the first layer, and an inner spacer disposed between the gate electrode and the first layer, between each of the plurality of nanosheets, the inner spacer in contact with the first layer, the inner spacer including a metal oxide formed by oxidizing the same material as the metal.

In general, in other aspects, the subject matter of the present disclosure can be embodied in semiconductor devices that include: a substrate, an active pattern extending in a first horizontal direction on the substrate, a plurality of nanosheets spaced apart from each other and stacked in a vertical direction on the active pattern, a gate electrode extending in a second horizontal direction different from the first horizontal direction on the active pattern, the gate electrode surrounding the plurality of nanosheets, a source/drain region disposed on at least one side of the gate electrode on the active pattern, the source/drain region including a first layer doped with either aluminum (Al) or nickel (Ni), and a second layer disposed on the first layer, a gate insulating layer disposed between the gate electrode and the first layer, between each of the plurality of nanosheets, and an inner spacer disposed between the gate electrode and the first layer, between each of the plurality of nanosheets, the inner spacer in contact with each of the first layer and the gate insulating layer, the inner spacer including any one of aluminum oxide and nickel oxide.

In general, in other aspects, the subject matter of the present disclosure can be embodied in semiconductor devices that include: a substrate, an active pattern extending in a first horizontal direction on the substrate, a plurality of nanosheets spaced apart from each other and stacked in a vertical direction on the active pattern, a gate electrode extending in a second horizontal direction different from the first horizontal direction on the active pattern, the gate electrode surrounding the plurality of nanosheets, a source/drain region disposed on at least one side of the gate electrode on the active pattern, the source/drain region including a first layer doped with aluminum (Al), and a second layer disposed on the first layer, and an inner spacer disposed between the gate electrode and the first layer, between each of the plurality of nanosheets, the inner spacer in contact with the first layer, the inner spacer including aluminum oxide, wherein the first layer does not in contact with each of upper and lower surfaces of the plurality of nanosheets between each of the plurality of nanosheets.

According to certain embodiments, a source/drain region includes a first layer doped with a metal, and an inner spacer is provided that comprises a metal oxide formed by oxidizing the same material as the metal. That is, the inner spacer may comprise an oxide of the same metal as that used to dope the first layer. This can improve the reliability of the source/drain region.

At least some of the above and other features of the invention are set out in the claims.

### BRIEF DESCRIPTION OF THE DRAWINGS

FIG. 1 is a schematic layout diagram of an example of a semiconductor device.
FIG. 2 is a cross-sectional view taken along a line A-A' of FIG. 1.
FIG. 3 is an enlarged view of a region R1 of FIG. 2.
FIG. 4 is a cross-sectional view taken along a line B-B' of FIG. 1.
FIGS. 5 to 16 are intermediate step diagrams for an example of a method of fabricating a semiconductor device.
FIG. 17 is a cross-sectional view of an example of a semiconductor device.
FIG. 18 is an enlarged view of a region R2 of FIG. 17.
FIG. 19 is a cross-sectional view of an example of a semiconductor device.
FIG. 20 is an enlarged view of a region R3 of FIG. 19.
FIG. 21 is a cross-sectional view of an example of a semiconductor device.
FIG. 22 is an enlarged view of a region R4 of FIG. 21.

### DETAILED DESCRIPTION OF THE EMBODIMENTS

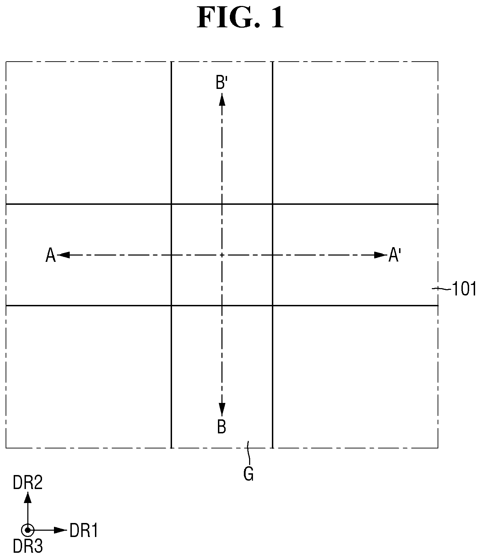

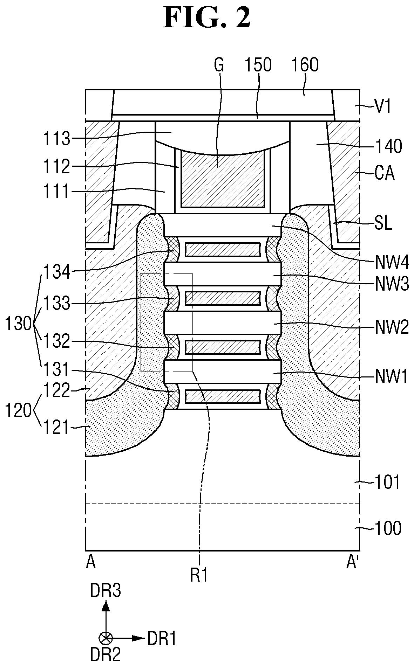

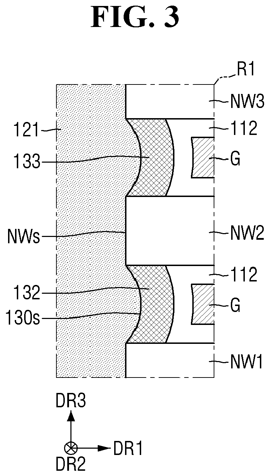

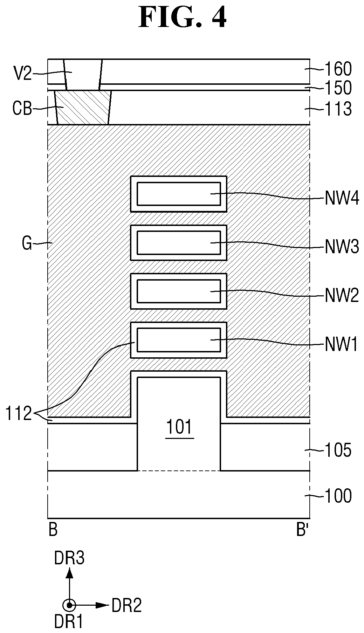

FIG. 1 is a schematic layout diagram of an example of a semiconductor device. FIG. 2 is a cross-sectional view taken along a line A-A' of FIG. 1. FIG. 3 is an enlarged view of a region R1 of FIG. 2. FIG. 4 is a cross-sectional view taken along a line B-B' of FIG. 1.

Referring to FIGS. 1 to 4, a semiconductor device according to some embodiments of the present disclosure includes a substrate 100, an active pattern 101, a field insulating layer 105, a plurality of nanosheets NW 1, NW2, NW3, and NW4, a gate electrode G, a gate spacer 111, a gate insulating layer 112, a capping pattern 113, a source/drain region 120, an inner spacer 130, a first interlayer insulating layer 140, a source/drain contact CA, a silicide layer SL, a gate contact CB, an etch stop layer 150, a second interlayer insulating layer 160, and first and second vias V1 and V2. In the implementations illustrated herein, the phrase source/drain region may be understood to mean a source terminal region and/or a drain terminal region of a transistor. A source/drain contact may be understood to mean a contact for either a source terminal region and/or a drain terminal region of a transistor. A source/drain trench may be understood to mean a trench associated with (e.g. containing) either a source terminal region and/or a drain terminal region of a transistor.

The substrate 100 may be a silicon substrate or silicon-on-insulator (SOI). In contrast, although the substrate 100 may include silicon germanium, silicon germanium on insulator (SGOI), indium antimonide, lead telluride, indium arsenide, indium phosphide, gallium arsenide or gallium antimonide, the present disclosure is not limited thereto.

Hereinafter, each of the first horizontal direction DR1 and the second horizontal direction DR2 are defined as a direction parallel to an upper surface of the substrate 100. The second horizontal direction DR2 is defined as a direction different from the first horizontal direction DR1. The second horizontal direction DR2 may be perpendicular to the first horizontal direction D1. A vertical direction DR3 is defined as a direction perpendicular to each of the first horizontal direction DR1 and the second horizontal direction DR2. That is, the vertical direction DR3 is defined as a direction perpendicular to the upper surface of the substrate 100.

The active pattern 101 may extend in the first horizontal direction DR1 on the substrate 100. The active pattern 101 may protrude from the upper surface of the substrate 100 in the vertical direction DR3. For example, the active pattern 101 may be a part of the substrate 100 and/or may include an epitaxial layer grown from the substrate 100.

The field insulating layer 105 may be disposed on the upper surface of the substrate 100. The field insulating layer 105 may surround side walls of the active pattern 101. For example, the upper surface of the active pattern 101 may protrude in the vertical direction DR3 beyond the upper surface of the field insulating layer 105. However, the present disclosure is not limited thereto. In some implementations, the upper surface of the active pattern 101 is formed on the same plane as the upper surface of the field insulating layer 105. The field insulating layer 105 may include, for example, an oxide film, a nitride film, an oxynitride film or a combination thereof.

A plurality of nanosheets NW1, NW2, NW3, and NW4 may be disposed on the active pattern 101. A nanosheet may be a structure having a thickness in a scale ranging from 1 to 100 nm. The plurality of nanosheets NW1, NW2, NW3, and NW4 may be stacked on the active pattern 101 while being spaced apart from each other in the vertical direction DR3. For example, the plurality of nanosheets NW1, NW2, NW3, and NW4 may include a first nanosheet NW1, a second nanosheet NW2, a third nanosheet NW3, and a fourth nanosheet NW4. The first nanosheet NW1 may be spaced apart from the active pattern 101 in the vertical direction DR3 on the active pattern 101. The second nanosheet NW2 may be spaced apart from the first nanosheet NW1 in the vertical direction DR3 on the first nanosheet NW1. The third nanosheet NW3 may be spaced apart from the second nanosheet NW2 in the vertical direction DR3 on the second nanosheet NW2. The fourth nanosheet NW4 may be spaced apart from the third nanosheet NW3 in the vertical direction DR3 on the third nanosheet NW3.

Although FIGS. 2 and 4 show that the plurality of nanosheets NW1, NW2, NW3, and NW4 include four nanosheets spaced apart from one another and stacked in the vertical direction DR3, this is only for convenience of explanation, and the present disclosure is not limited thereto. In some implementations, the plurality of nanosheets include three nanosheets spaced apart from each other and stacked in the vertical direction DR3. Furthermore, in some implementations, the plurality of nanosheets include five or more nanosheets spaced apart from each other and stacked in the vertical direction DR3. That is, the semiconductor device may comprise any number of nanosheets. In one example, each of the first to fourth nanosheets NW1, NW2, NW3, and NW4 may include silicon (Si). However, the present disclosure is not limited thereto. In some implementations, each of the first through fourth nanosheets NW1, NW2, NW3, and NW4 includes silicon germanium (SiGe).

The gate electrode G may extend in the second horizontal direction DR2 on the active pattern 101 and the field insulating layer 105. The gate electrode G may surround each of the first to fourth nanosheets NW1, NW2, NW3, and NW4. For instance, the gate electrode G may surround top, bottom and two side surfaces of each of the first to fourth nanosheets NW1, NW2, NW3, and NW4. The two side surfaces of each of the first to fourth nanosheets NW1, NW2, NW3, and NW4 may run perpendicular to the second direction horizontal DR2. The gate electrode G may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof. The gate electrode G may include a conductive metal oxide, a conductive metal oxynitride, or the like, and may include oxidized forms of the aforementioned materials.

The gate spacer 111 may extend in the second horizontal direction DR2 along both side walls of the gate electrode G on the upper surface of the uppermost nanosheet of the plurality of nanosheets NW1, NW2, NW3, and NW4 and the field insulating layer 105. For example, the gate spacer 111 may extend in the second horizontal direction DR2 along both side walls of the gate electrode G on the upper surface of the fourth nanosheet NW4 and the field insulating layer 105. The gate spacer 111 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and combinations thereof. However, the present disclosure is not limited thereto.

The source/drain region 120 may be disposed on at least one side of the gate electrode G on the active pattern 101. For example, the source/drain region 120 may be disposed on both sides of the gate electrode G on the active pattern 101. The source/drain regions 120 may be in contact with both side walls in the first horizontal direction DR1 of each of the plurality of nanosheets NW1, NW2, NW3, and NW4. For example, the upper surface of the source/drain region 120 may be formed to be higher than the upper surface of the fourth nanosheet NW4. The source/drain region 120 may include a first layer 121, and a second layer 122 disposed on the first layer 121.

The first layer 121 may be disposed along side walls and a bottom surface of the source/drain region 120 in a cross-section taken along the first horizontal direction DR1. The first layer 121 may be in contact with the upper surface of the active pattern 101 and both side walls of each of the plurality of nanosheets NW1, NW2, NW3, and NW4 in the first horizontal direction DR1. The first layer 121 may be in contact with an inner spacer 130, which will be described later. For example, the first layer 121 may be in contact with the gate spacer 111. In one embodiment, the first layer 121 does not contact the upper surface and lower surface of each of the plurality of nanosheets NW1, NW2, NW3, and NW4 between each of the plurality of nanosheets NW 1, NW2, NW3, and NW4.

The first layer 121 may include a semiconductor (e.g. silicon, germanium, or silicon germanium) doped with a metal (e.g. aluminum or nickel). For example, the first layer 121 may comprise silicon germanium (SiGe). For example, the first layer 121 may include a doped metal. That is, the first layer 121 may be doped with a metal. For example, the metal doped in the first layer 121 (the metal dopant) may be either aluminum (Al) or nickel (Ni). For example, when the substrate 100 is a PMOS region, the metal doped in the first layer 121 may be aluminum (Al). For example, if the substrate 100 is an NMOS region, the metal doped in the first layer 121 may be nickel (Ni).

The second layer 122 may be disposed on the first layer 121 in a cross-section taken along the first horizontal direction DR1. For example, the second layer 122 may be in contact with the first layer 121. For example, the second layer 122 may be in contact with the gate spacer 111. For example, the upper surface of the second layer 122 may be formed to be higher than the upper surface of the fourth nanosheet NW4.

The second layer 122 may include, for example, silicon germanium (SiGe). For example, the concentration of germanium (Ge) contained in the second layer 122 may be greater than the concentration of germanium (Ge) contained in the first layer 121. For example, when the substrate 100 is a PMOS region, the second layer 122 may include doped P-type impurities. For example, the P-type impurities may be boron (B) or carbon (C), but the present disclosure is not limited thereto. For example, when the substrate 100 is an NMOS region, the second layer 122 may include doped N-type impurities. For example, the N-type impurities may include one of phosphorus (P), arsenic (As), antimony (Sb), and bismuth (Bi), but the present disclosure is not limited thereto.

An inner spacer 130 may be disposed between the gate electrode G and the first layer 121, between each of the plurality of nanosheets NW1, NW2, NW3, and NW4. Also, the inner spacer 130 may be disposed between the gate electrode G and the first layer 121, between the active pattern 101 and the first nanosheet NW1. The inner spacer 130 may be in contact with the first layer 121. For example, the inner spacer 130 may include first through fourth portions 131, 132, 133, and 134.

For example, a first portion 131 of the inner spacer 130 may be disposed between the gate electrode G and the first layer 121, between the active pattern 101 and the first nanosheet NW1. A second portion 132 of the inner spacer 130 may be disposed between the gate electrode G and the first layer 121, between the first nanosheet NW1 and the second nanosheet NW2. A third portion 133 of the inner spacer 130 may be disposed between the gate electrode G and the first layer 121, between the second nanosheet NW2 and the third nanosheet NW3. A fourth portion 134 of the inner spacer 130 may be disposed between the gate electrode G and the first layer 121, between the third nanosheet NW3 and the fourth nanosheet NW4.

For example, the inner spacer 130 may be in contact with the active pattern 101 and each of the plurality of nanosheets NW1, NW2, NW3, and NW4. For example, the inner spacer 130 may be in contact with each of the upper surface of the active pattern 101 and the lower surface of the first nanosheet NW1 between the active pattern 101 and the first nanosheet NW1. The inner spacer 130 may be in contact with each of the upper surface of the first nanosheet NW1 and the lower surface of the second nanosheet NW2 between the first nanosheet NW1 and the second nanosheet NW2. The inner spacer 130 may be in contact with each of the upper surface of the second nanosheet NW2 and the lower surface of the third nanosheet NW3 between the second nanosheet NW2 and the third nanosheet NW3. The inner spacer 130 may be in contact with each of the upper surface of the third nanosheet NW3 and the lower surface of the fourth nanosheet NW4 between the third nanosheet NW3 and the fourth nanosheet NW4.

For example, the side wall 130s of the inner spacer 130 in contact with the first layer 121 may be formed concavely toward the gate electrode G beyond the side walls NWs of each of the plurality of nanosheets NW1, NW2, NW3, and NW4 in the first horizontal direction DR1. That is, the side wall 130s of the inner spacer 130 that faces the first layer 121 may be concave (e.g. may include a recess). For example, the inner spacer 130 may include metal oxide formed by oxidizing the same material as the metal dopant in the first layer 121. That is, the inner spacer may include an oxide of the same metal as the metal dopant in the first layer 121. For example, the metal oxide included in the inner spacer 130 may be either aluminum oxide or nickel oxide. For example, when the metal doped in the first layer 121 is aluminum (Al), the inner spacer 130 may include aluminum oxide. For example, when the metal doped in first layer 121 is nickel (Ni), the inner spacer 130 may include nickel oxide.

A gate insulating layer 112 may be disposed between the gate electrode G and the gate spacer 111. The gate insulating layer 112 may be disposed between the gate electrode G and the active pattern 101. The gate insulating layer 112 may be disposed between the gate electrode G and each of the plurality of nanosheets NW1, NW2, NW3 and NW4. The gate insulating layer 112 may be disposed between the gate electrode G and the first layer 121. The gate insulating layer 112 may be disposed between the gate electrode G and the inner spacer 130. The gate insulating layer 112 may be in contact with the inner spacer 130.

The gate insulating layer 112 may include at least one of silicon oxide, silicon oxynitride, silicon nitride, or a high dielectric constant material (e.g. a material having a higher dielectric constant than silicon oxide). The high dielectric constant material may include, for example, one or more of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

The semiconductor device according to some embodiments may include an NC (Negative Capacitance) FET (Field Effect Transistor) that uses a negative capacitor. For example, the gate insulating layer 112 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. By the use of the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a dopant, e.g., be doped. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which type of ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, a silicon oxide and a metal oxide having a high dielectric constant. The metal oxide included in the paraelectric material film may include, for example, but is not limited to, at least one of hafnium oxide, zirconium oxide, and aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a threshold thickness for exhibiting ferroelectric properties, e.g., behaving like a bulk version of the crystal. A thickness of the ferroelectric material film may be, for example, but is not limited to, 0.5 to 10 nm. Since a critical thickness that exhibits the ferroelectric properties may vary for each ferroelectric material, the thickness of the ferroelectric material film may vary depending on the ferroelectric material.

As an example, each of the gate insulating layer 112 may include one ferroelectric material film. As another example, the gate insulating layer 112 may include a plurality of ferroelectric material films spaced apart from each other. The gate insulating layer 112 may have a stacked film structure in which the plurality of ferroelectric material films and the plurality of paraelectric material films are alternately stacked.

The capping pattern 113 may extend in the second horizontal direction DR2 on each of the gate spacer 111, the gate insulating layer 112 and the gate electrode G. For example, the capping pattern 113 may be in contact with the upper surface of the gate spacer 111. However, the present disclosure is not limited thereto. In some implementations, the capping pattern 113 is disposed between the gate spacers 111. The capping pattern 113 may include, for example, at least one of silicon nitride (SiN), silicon oxynitride (SiON), silicon oxide (SiO₂), silicon carbonitride (SiCN), silicon oxycarbonitride (SiOCN), and combinations thereof. However, the present disclosure is not limited thereto.

A first interlayer insulating layer 140 may be disposed on the field insulating layer 105. The first interlayer insulating layer 140 may cover the source/drain region 120. The first interlayer insulating layer 140 may surround side walls of each of the gate spacer 111 and the capping pattern 113. For example, the upper surface of the first interlayer insulating layer 140 may be formed on the same plane as the upper surface of the capping pattern 113. However, the present disclosure is not limited thereto. In some implementations, the first interlayer insulating layer 140 covers the upper surface of the capping pattern 113.

The first interlayer insulating layer 140 may include, for example, at least one of silicon oxide, silicon nitride, silicon oxynitride, and a low dielectric constant material. Although the low dielectric constant material may include, for example, Fluorinated TetraEthylOrthoSilicate (FTEOS), Hydrogen SilsesQuioxane (HSQ), BisbenzoCycloButene (BCB), TetraMethylOrthoSilicate (TMOS), OctaMethyleyCloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), TOSZ (Tonen SilaZen), FSG (Fluoride Silicate Glass), polyimide nanofoams such as polypropylene oxide, CDO (Carbon Doped silicon Oxide), OSG (Organo Silicate Glass), SiLK, Amorphous Fluorinated Carbon, silica aerogels, silica xerogels, mesoporous silica or combinations thereof, but the present disclosure is not limited thereto.

The source/drain contact CA penetrates the first interlayer insulating layer 140 in the vertical direction DR3 and connects to the source/drain region 120. For example, the source/drain contact CA penetrates the first interlayer insulating layer 140 in the vertical direction DR3 and may be connected to the second layer 122. For example, the upper surface of the source/drain contact CA may be formed on the same plane as the upper surface of the first interlayer insulating layer 140. In FIG. 2, although the source/drain contact CA is shown as being formed of a single film, the present disclosure is not limited thereto. In some implementations, the source/drain contact CA is formed of multiple films.

The source/drain contact CA may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu), and molybdenum (Mo).

A silicide layer SL may be disposed between the source/drain contact CA and the source/drain region 120. For example, the silicide layer SL may be disposed between the source/drain contact CA and the second layer 122. The silicide layer SL may include, for example, a metal silicide material.

The gate contact CB penetrates the capping pattern 113 in the vertical direction DR3, and may be connected to the gate electrode G. For example, the upper surface of the gate contact CB may be formed on the same plane as the upper surface of the first interlayer insulating layer 140. In FIG. 4, although the gate contact CB is shown as being formed of a single layer, the present disclosure is not limited thereto. In some implementations, the gate contact CB is formed of multiple films.

The gate contact CB may include, for example, at least one of tantalum (Ta), tantalum nitride (TaN), titanium (Ti), titanium nitride (TiN), ruthenium (Ru), cobalt (Co), nickel (Ni), nickel boron (NiB), tungsten (W), tungsten nitride (WN), zirconium (Zr), zirconium nitride (ZrN), vanadium (V), vanadium nitride (VN), niobium (Nb), niobium nitride (NbN), platinum (Pt), iridium (Ir), rhodium (Rh), aluminum (Al), copper (Cu) and molybdenum (Mo).

The etch stop layer 150 may be disposed on upper surfaces of each of the first interlayer insulating layer 140, the capping pattern 113, the source/drain contact CA, and the gate contact CB. Although FIGS. 2 and 4 show that the etch stop layer 150 is formed of a single film, the present disclosure is not limited thereto. In some implementations, the etch stop layer 150 is formed of multiple films. The etch stop layer 150 may include, for example, at least one of aluminum oxide, aluminum nitride, hafnium oxide, zirconium oxide, silicon oxide, silicon nitride, silicon oxynitride, and a low dielectric constant material. The second interlayer insulating layer 160 may be disposed on the etch stop layer 150. The second interlayer insulating layer 160 may include, for example, at least one of silicon oxide, silicon nitride, silicon oxynitride, and a low dielectric constant material.

A first via V1 penetrates the second interlayer insulating layer 160 and the etch stop layer 150 in the vertical direction DR3, and may be connected to the source/drain contact CA. A second via V2 penetrates the second interlayer insulating layer 160 and the etch stop layer 150 in the vertical direction DR3 and may be connected to the gate contact CB. Although FIGS. 2 and 4 show that each of the first via V1 and the second via V2 is formed of a single film, the present disclosure is not limited thereto. In some implementations, each of the first via V1 and the second via V2 is formed of multiple films. Each of the first via V1 and the second via V2 may include a conductive material.

A method of fabricating a semiconductor device according to some embodiments of the present disclosure will be described below with reference to FIGS. 2 to 16.

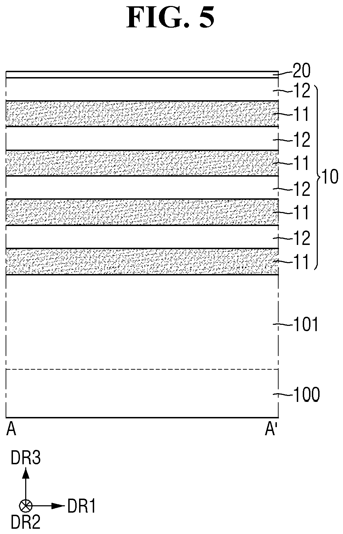

FIGS. 5 to 16 are intermediate step diagrams for explaining the method of fabricating the semiconductor device.

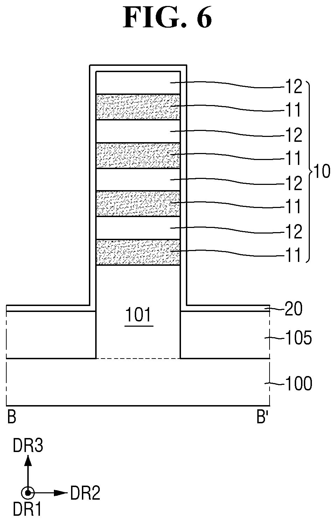

Referring to FIGS. 5 and 6, a stacked structure 10 may be formed on the substrate 100. The stacked structure 10 may include a sacrificial layer 11 and a semiconductor layer 12 that are alternately stacked on the substrate 100. For example, the sacrificial layer 11 may be formed at the lowermost part of the stacked structure 10, and the semiconductor layer 12 may be formed at the uppermost part of the stacked structure 10. However, the present disclosure is not limited thereto. In some implementations, the sacrificial layer 11 is formed at the uppermost part of the stacked structure 10. The sacrificial layer 11 may include, for example, silicon germanium (SiGe). The semiconductor layer 12 may include, for example, silicon (Si).

A part of the stacked structure 10 may then be etched. A part of the substrate 100 may also be etched, while the stacked structure 10 is being etched. Through such an etching process, an active pattern 101 may be defined under the stacked structure 10 on the upper surface of the substrate 100. The active pattern 101 may extend in the first horizontal direction DR1. The field insulating layer 105 may then be formed on the upper surface of the substrate 100. The field insulating layer 105 may surround the side walls of the active pattern 101. For example, the upper surface of the active pattern 101 may be formed to be higher than the upper surface of the field insulating layer 105.

Subsequently, a pad oxide layer 20 may be formed to cover the upper surface of the field insulating layer 105, the side walls of the exposed active pattern 101, and the side walls and the upper surface of the stacked structure 10. For example, the pad oxide layer 20 may be formed conformally. The pad oxide layer 20 may include, for example, silicon oxide (SiO₂).

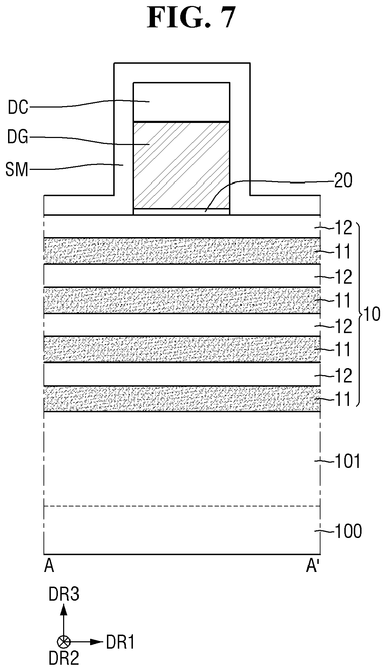

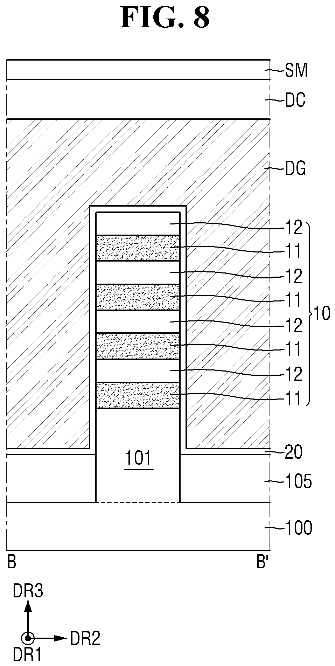

Referring to FIGS. 7 and 8, the dummy gate DG and the dummy capping pattern DC extending in the second horizontal direction DR2 on the pad oxide layer 20 may be formed on the stacked structure 10 and the field insulating layer 105. The dummy capping pattern DC may be disposed on the dummy gate DG. While the dummy gate DG and the dummy capping pattern DC are being formed, the remaining pad oxide layer 20 except for the portion that overlaps the dummy gate DG in the vertical direction DR3 on the substrate 100 may be removed.

Next, a spacer material layer SM may be formed to cover the side walls of each of the dummy gate DG, the side walls and upper surfaces of each of the dummy capping patterns DC, side walls and upper surface of the exposed stacked structure 10, and the upper surface of the field insulating layer 105. For example, the spacer material layer SM may be formed conformally. The spacer material layer SM may include, for example, at least one of silicon nitride (SiN), silicon oxycarbonitride (SiOCN), silicon boron carbonitride (SiBCN), silicon carbonitride (SiCN), silicon oxynitride (SiON), and combinations thereof.

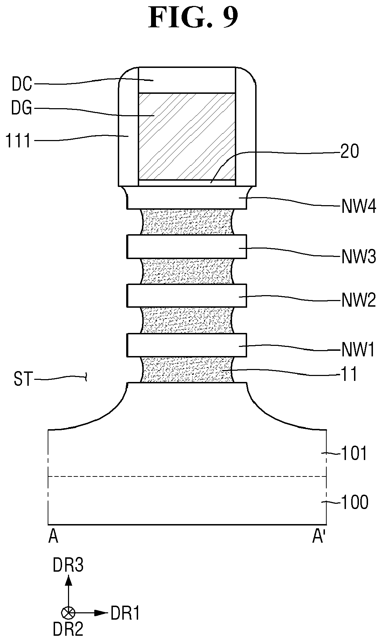

Referring to FIG. 9, the stacked structure 10 (see FIG. 7) may be etched using the dummy capping pattern DC and the dummy gate DG as masks, thereby forming a source/drain trench ST. For example, the source/drain trench ST may extend into the inside of the active pattern 101. During the formation of the source/drain trench ST, each of the spacer material layer SM (see FIG. 7) formed on the upper surface of the dummy capping pattern DC and the dummy capping pattern DC may be partially etched. In addition, both side walls of the sacrificial layer 11 in the first horizontal direction DR1 may be partially etched during the formation of the source/drain trench ST. Accordingly, both side walls of the sacrificial layer 11 in the first horizontal direction DR1 may be formed to be recessed toward the center.

Referring to FIG. 7, a spacer material layer SM that remains on side walls of each of the dummy capping pattern DC and the dummy gate DG may be defined as the gate spacer 111. For example, after the source/drain trench ST is formed, each of the semiconductor layers 12 that remains under the dummy gate DG on the active pattern 101 may be defined as the first to fourth nanosheets NW1, NW2, NW3, and NW4.

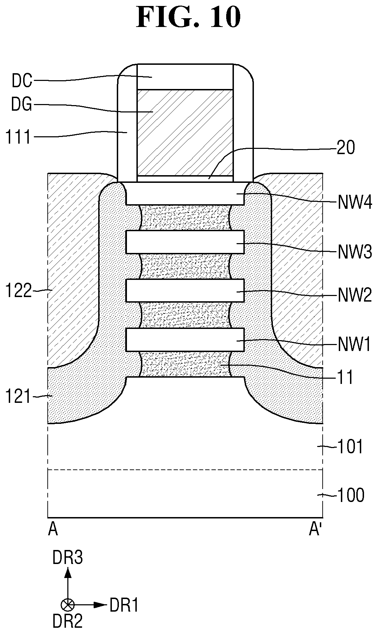

Referring to FIG. 10, a first layer 121 may be formed along the side walls and bottom surface of the source/drain trench ST (see FIG. 9). For example, the first layer 121 may be epitaxially grown from each of the active pattern 101, the sacrificial layer 11, and the first to fourth nanosheets NW1, NW2, NW3, and NW4. The first layer 121 may be in contact with each of the active pattern 101, the sacrificial layer 11, and the first to fourth nanosheets NW 1, NW2, NW3, and NW4.

For example, at least a part of the first layer 121 may be formed between the active pattern 101 and the first nanosheet NW1. Also, at least a part of the first layer 121 may be formed between each of the first to fourth nanosheets NW1, NW2, NW3, and NW4. For example, the first layer 121 may include silicon germanium (SiGe). For example, the first layer 121 may include a doped metal. That is, the first layer 121 may be doped with a metal. For example, the metal doped in the first layer 121 (the metal dopant) may be either aluminum (Al) or nickel (Ni). Next, a second layer 122 may be formed on the first layer 121 to fill the inside of the source/drain trench ST (see FIG. 9).

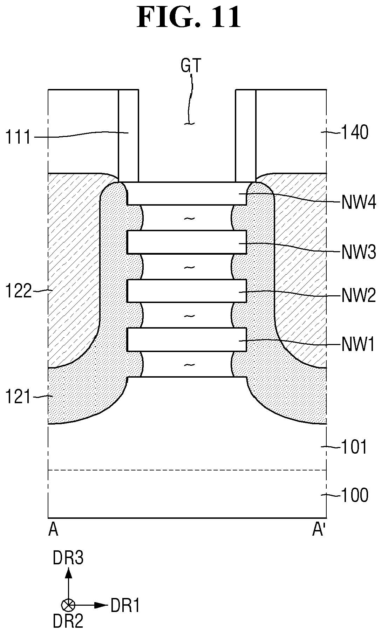

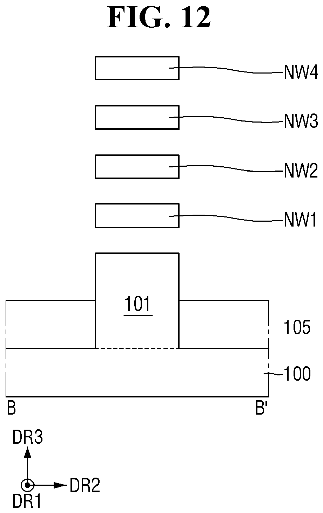

Referring to FIGS. 11 and 12, a first interlayer insulating layer 140 may be formed to cover each of the first layer 121, the second layer 122, the gate spacer 111 and the dummy capping pattern DC (see FIG. 10). The upper surface of the dummy gate DG may then be exposed through a planarization process. Subsequently, each of the dummy gate DG, the pad oxide layer 20 and the sacrificial layer 11 (see FIG. 10) may be etched. A portion from which the dummy gate DG (see FIG. 10) is removed may be defined as a gate trench GT.

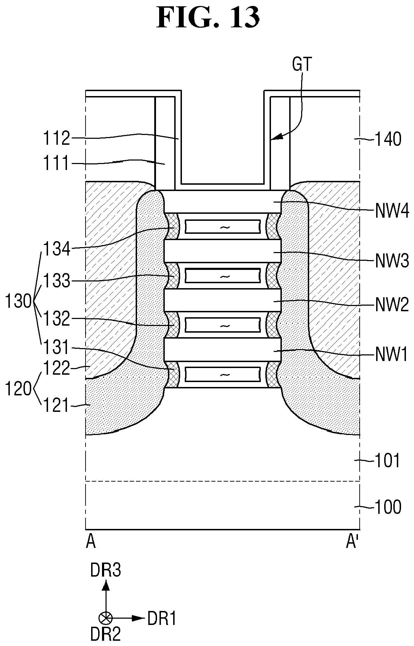

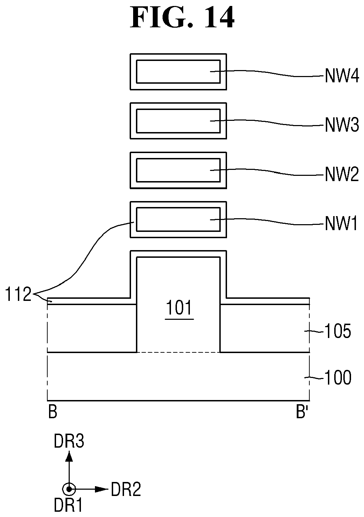

Referring to FIGS. 13 and 14, the gate insulating layer 112 may be formed on the portion which each of the dummy gate DG (see FIG. 10), the pad oxide layer 20 (see FIG. 10) and the sacrificial layer 11 (see FIG. 10) is etched. For example, the gate insulating layer 112 may be formed along the side walls and bottom surface of the gate trench GT. The gate insulating layer 112 may also be formed on the upper surface of the first interlayer insulating layer 140. For example, the gate insulating layer 112 may be conformally formed.

For example, during the formation of the gate insulating layer 112, a part of the first layer 121 that is in contact with the gate insulating layer 112 may be oxidized to form the inner spacer 130. That is, a part of the first layer 121 may be converted into the inner spacer 130. After the inner spacer 130 is formed, the remaining first layer 121 and second layer 122 may be defined as the source/drain region 120.

For example, the inner spacer 130 may include metal oxide formed by oxidizing the same material as the metal doped in the first layer 121. For example, the metal oxide included in the inner spacer 130 may be either aluminum oxide or nickel oxide. For example, when the metal doped in the first layer 121 is aluminum (Al), the inner spacer 130 may include aluminum oxide. For example, when the metal doped in the first layer 121 is nickel (Ni), the inner spacer 130 may include nickel oxide. For example, the inner spacer 130 may be defined as a portion that does not include silicon germanium (SiGe) and includes either aluminum oxide or nickel oxide.

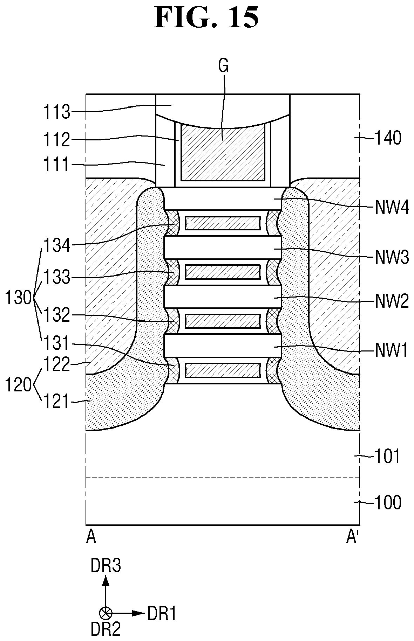

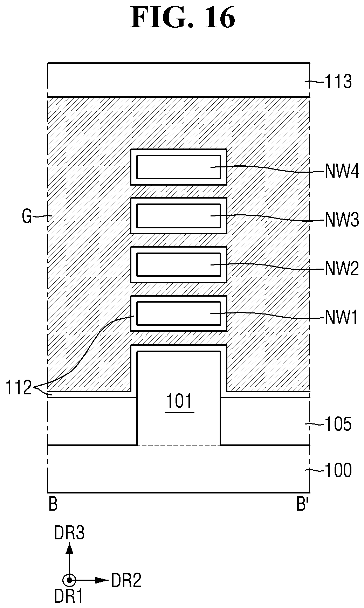

Referring to FIGS. 15 and 16, a gate electrode G may be formed on the gate insulating layer 112. Subsequently, an upper surface of the first interlayer insulating layer 140 may be exposed through the planarization process. Subsequently, the upper parts of each of the gate spacer 111, the gate insulating layer 112, and the gate electrode G may be partially etched. A capping pattern 113 may be formed on the portion in which each of the gate spacer 111, the gate insulating layer 112, and the gate electrode G is etched.

Referring to FIGS. 2 to 4, the source/drain contact CA which penetrates the first interlayer insulating layer 140 in the vertical direction DR3 and is connected to the source/drain region 120 may be formed. Also, the gate contact CB which penetrates the capping pattern 113 in the vertical direction DR3 and is connected to the gate electrode G may be formed. Subsequently, the etch stop layer 150 and the second interlayer insulating layer 160 may be sequentially formed on the first interlayer insulating layer 140, the capping pattern 113, the source/drain contact CA, and the gate contact CB.

Subsequently, the first via V1 that penetrates the etch stop layer 150 and the second interlayer insulating layer 160 in the vertical direction DR3 and is connected to the source/drain contact CA may be formed. Also, the second via V2 that penetrates the etch stop layer 150 and the second interlayer insulating layer 160 in the vertical direction DR3 and is connected to the gate contact CB may be formed. The semiconductor device shown in FIGS. 2 to 4 may be fabricated through such a fabricating process.

When the inner spacer 130 is formed on the side walls of the sacrificial layer 11 before the source/drain region 120 is formed, since the source/drain region 120 is not epitaxially grown from the sacrificial layer 11, the reliability of the source/drain region 120 suffers. However, when the inner spacer 130 is formed on side walls of the source/drain region 120 after the dummy gate DG is removed, the reliability of the source/drain region 120 can improve. That is, in some semiconductor devices according the present disclosure, the inner spacer 130 may be formed on the side walls of the source/drain regions 120 after the source/drain region 120 is formed.

In some implementations, the first layer 121 of the source/drain regions 120 adjacent to a plurality of nanosheets NW1, NW2, NW3, and NW4 includes any one of doped aluminum (Al) or nickel (Ni), and aluminum (Al) or nickel (Ni) doped in the first layer 121 of the source/drain region 120, where the doped Al or Ni is oxidized in the process of forming the gate insulating layer 112 to form the inner spacer 130 including aluminum oxide or nickel oxide. Therefore, in some implementations, the semiconductor device can improve the reliability on each of the source/drain region 120 and the inner spacer 130.

In some implementations, a semiconductor device fabricated through such a fabricating method includes the first layer 121 of the source/drain region 120, which includes one of doped aluminum (Al) and nickel (Ni), and the inner spacer 130 may include one of aluminum oxide and nickel oxide. In some implementations, a semiconductor device fabricated through such a fabricating method includes the first layer 121 of the source/drain region 120 which is doped with a metal (e.g. aluminum (Al) or nickel (Ni)), and the inner spacer 130 includes an oxide of the metal (e.g. one of aluminum oxide and nickel oxide).

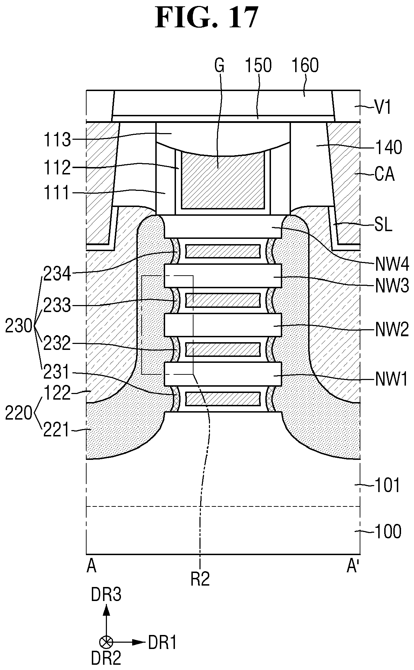

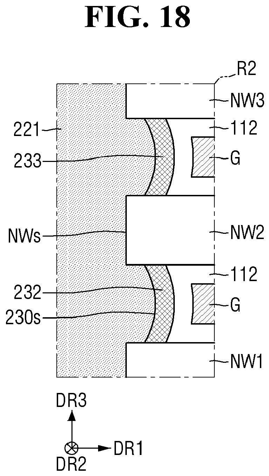

Hereinafter, an example of a semiconductor device will be described with reference to FIGS. 17 and 18. The description will focus on differences from the semiconductor device shown in FIGS. 1 to 4.

FIG. 17 is a cross-sectional view for explaining the semiconductor device. FIG. 18 is an enlarged view of a region R2 of FIG. 17.

Referring to FIGS. 17 and 18, in some implementations, between each of a plurality of nanosheets NW1, NW2, NW3, and NW4, at least a part of the first layer 221 of the source/drain region 220 is in contact with the lower surfaces of each of the plurality of nanosheets NW 1, NW2, NW3, and NW4.

For example, at least a part of the source/drain region 220 may be in contact with each of the uppermost surface of the active pattern 101 and the lower surface of the first nanosheet NW1 between the active pattern 101 and the first nanosheet NW1. At least a part of the source/drain region 220 may be in contact with each of the upper surface of the first nanosheet NW1 and the lower surface of the second nanosheet NW2, between the first nanosheet NW1 and the second nanosheet NW2. At least a part of the source/drain region 220 may be in contact with each of the upper surface of the second nanosheet NW2 and the lower surface of the third nanosheet NW3, between the second nanosheet NW2 and the third nanosheet NW3. At least a part of the source/drain region 220 may be in contact with each of the upper surface of the third nanosheet NW3 and the lower surface of the fourth nanosheet NW4, between the third nanosheet NW3 and the fourth nanosheet NW4.

For example, the inner spacer 230 may include first through fourth portions 231, 232, 233, and 234. For example, side walls 230s of each of the first to fourth portions 231, 232, 233, and 234 of the inner spacer 230 in contact with the first layer 221 may be formed concavely toward the gate electrode G beyond the side walls NWs in the first horizontal direction DR1 of each of the plurality of nanosheets NW 1, NW2, NW3, and NW4.

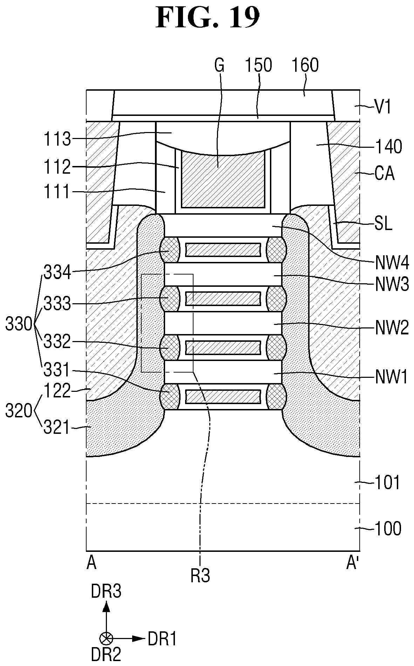

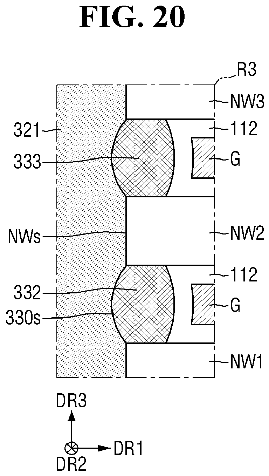

Hereinafter, an example of a semiconductor device will be described with reference to FIGS. 19 and 20. The description will focus on differences from the semiconductor device shown in FIGS. 1 to 4.

FIG. 19 is a cross-sectional view for explaining a semiconductor device. FIG. 20 is an enlarged view of a region R3 of FIG. 19.

Referring to FIGS. 19 and 20, in some implementations, the side walls 330s of the inner spacer 330 in contact with the first layer 321 of the source/drain region 320 are formed convexly toward the first layer 321 beyond the side walls NWs in the first horizontal direction DR1 of each of the plurality of nanosheets NW1, NW2, NW3, and NW4. That is, the side walls 330s of the inner spacer 330 that face the first layer 321 may be convex. The side walls 330s may protrude outwards (e.g. protrude beyond the beyond the side walls NWs of each of the plurality of nanosheets NW 1, NW2, NW3, and NW4).

For example, the inner spacer 330 may include first through fourth portions 331, 332, 333, and 334. For example, side walls 330s of each of the first to fourth portions 331, 332, 333, and 334 of the inner spacer 330 in contact with the first layer 321 of the source/drain region 320 may be formed convexly toward the first layer 321 beyond the side walls NWs in the first horizontal direction DR1 of each of the plurality of nanosheets NW1, NW2, NW3, and NW4.

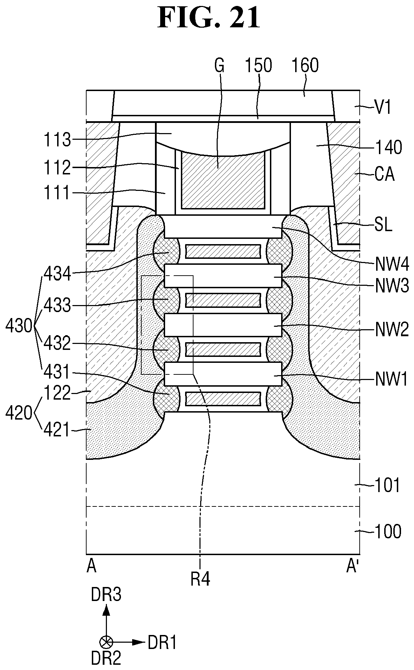

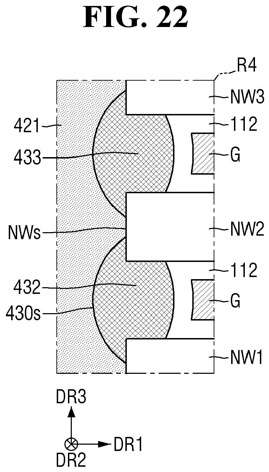

Hereinafter, an example of a semiconductor device will be described with reference to FIGS. 21 and 22. The description will focus on differences from the semiconductor device shown in FIGS. 1 to 4.

FIG. 21 is a cross-sectional view for explaining a semiconductor device. FIG. 22 is an enlarged view of a region R4 of FIG. 21.

Referring to FIGS. 21 and 22, in the semiconductor device according to still some other embodiments of the present disclosure, at least a part of the inner spacer 430 may be in contact with side walls NWs in the first horizontal direction DR1 of each of the plurality of nanosheets NW 1, NW2, NW3, and NW4.

For example, the inner spacer 430 may include first through fourth portions 431, 432, 433, and 434. For example, side walls 430s of each of the first to fourth portions 431, 432, 433, and 434 of the inner spacer 430 in contact with the first layer 421 of the source/drain region 420 may be formed convexly toward the first layer 421 beyond the side walls NWs in the first horizontal direction DR1 of each of the plurality of the nanosheets NW 1, NW2, NW3, and NW4.

For example, at least a part of the first portion 431 of the inner spacer 430 may be in contact with side walls of the active pattern 101 adjacent to the uppermost surface of the active pattern 101. At least a part of the first portion 431 of the inner spacer 430 may be in contact with side walls NWs of the first nanosheet NW1 in the first horizontal direction DR1. At least a part of the second portion 432 of the inner spacer 430 may be in contact with side walls NWs in the first horizontal direction DR1 of each of the first nanosheet NW1 and the second nanosheet NW2. At least a part of the third portion 433 of the inner spacer 430 may be in contact with side walls NWs in the first horizontal direction DR1 of each of the second nanosheet NW2 and the third nanosheet NW3. At least a part of the fourth portion 434 of the inner spacer 430 may be in contact with side walls NWs in the first horizontal direction DR1 of each of the third nanosheet NW3 and the fourth nanosheet NW4.

For example, between the first portion 431 of the inner spacer 430 and the second portion 432 of the inner spacer 430, the side walls NWs in the first horizontal direction DR1 of the first nanosheet NW1 may be in contact with the first layer 421. Between the second portion 432 of the inner spacer 430 and the third portion 433 of the inner spacer 430, the side walls NWs of the second nanosheet NW2 in the first horizontal direction DR1 may be in contact with the first layer 421. Between the third portion 433 of the inner spacer 430 and the fourth portion 434 of the inner spacer 430, the side walls NWs of the third nanosheet NW3 in the first horizontal direction DR1 may be in contact with the first layer 421. Between the fourth portion 434 of the inner spacer 430 and the gate spacer 111, the side walls NWs of the fourth nanosheet NW4 in the first horizontal direction DR1 may be in contact with the first layer 421.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

While the embodiments according to the present disclosure have been described above with reference to the accompanying drawings, the present disclosure is not limited to the above embodiments, and may be fabricated in various forms. Those skilled in the art will appreciate that the present disclosure may be embodied in other specific forms without changing the technical idea or essential features of the present disclosure. Accordingly, the above-described embodiments should be understood in all respects as illustrative and not restrictive.

## Claims

1. A semiconductor device comprising:
a substrate;
an active pattern extending in a first horizontal direction on the substrate;
a plurality of nanosheets spaced apart from each other and stacked in a vertical direction on the active pattern;
a gate electrode extending in a second horizontal direction different from the first horizontal direction on the active pattern, the gate electrode surrounding the plurality of nanosheets;
a source/drain region disposed on at least one side of the gate electrode on the active pattern, the source/drain region comprising a first layer doped with a metal, and a second layer disposed on the first layer; and
an inner spacer disposed between the gate electrode and the first layer, between each of the plurality of nanosheets, the inner spacer being in contact with the first layer, the inner spacer comprising a metal oxide formed by oxidizing a same material as the metal.

2. The semiconductor device of claim 1, wherein the metal comprises either aluminum or nickel.

3. The semiconductor device of claim 2, wherein the substrate is a p-channel metal-oxide-semiconductor, PMOS, region, the metal is aluminum, and the metal oxide is aluminum oxide.

4. The semiconductor device of claim 2, wherein the substrate is an n-channel metal-oxide-semiconductor, NMOS, region, the metal is nickel, and the metal oxide is nickel oxide.

5. The semiconductor device of any preceding claim, further comprising: a gate insulating layer disposed between the gate electrode and the inner spacer, the gate insulating layer contacting the inner spacer.

6. The semiconductor device of any preceding claim, wherein upper and lower surfaces of the inner spacer between each of the plurality of nanosheets contact the plurality of nanosheets.

7. The semiconductor device of any preceding claim, wherein the first layer does not contact each of upper and lower surfaces of the plurality of nanosheets between each of the plurality of nanosheets.

8. The semiconductor device of any preceding claim, wherein side walls of the inner spacer contacting the first layer are formed concavely toward the gate electrode beyond side walls of the plurality of nanosheets in the first horizontal direction.

9. The semiconductor device of any of claims 1-8, wherein side walls of the inner spacer contacting the first layer are formed convexly toward the first layer beyond side walls of the plurality of nanosheets in the first horizontal direction.

10. The semiconductor device of any preceding claim, wherein at least a part of the first layer between each of the plurality of nanosheets contacts lower surfaces of each of the plurality of nanosheets.

11. The semiconductor device of any preceding claim, wherein at least a part of the inner spacer contacts side walls of the plurality of nanosheets in the first horizontal direction.

12. A semiconductor device according to any preceding claim, wherein:
the first layer is doped with either aluminum or nickel;
the semiconductor device comprises a gate insulating layer disposed between the gate electrode and the first layer, wherein the gate insulating layer is disposed between adjacent nanosheets of the plurality of nanosheets;
the inner spacer contacts the gate insulating layer; and
the inner spacer comprises aluminum oxide or nickel oxide.

13. The semiconductor device of claim 12, wherein at least a part of the inner spacer contacts side walls of the plurality of nanosheets in the first horizontal direction.
